# EUROPEAN PATENT SPECIFICATION

(11) **EP 4 451 813 B1**
(45) Date of publication and mention of the grant of the patent: **14.10.2026**
(21) Application number: 24169310.0
(22) Date of filing: 09.04.2024
(51) Int. Cl.: H05K 3/38, H05K 3/14, H05K 3/42

(54) **INCREASING ADHESION OF METAL- ORGANIC INTERFACES BY SILANE VAPOR TREATMENT**
ERHÖHUNG DER HAFTUNG VON METALLORGANISCHEN GRENZFLÄCHEN DURCH SILANDAMPFBEHANDLUNG
AUGMENTATION DE L'ADHÉRENCE D'INTERFACES MÉTAL-ORGANIQUES PAR TRAITEMENT À LA VAPEUR DE SILANE

(30) Priority: 21.04.2023 US 202318137876
(43) Date of publication of application: 23.10.2024
(73) Proprietor: Yield Engineering Systems, Inc., Fremont, CA 94538 (US)
(72) Inventor: Sautter, Kenneth, Fremont, 94538 (US); Young, Syndee, Fremont, 94538 (US); Galande, Charudatta, Fremont, 94538 (US)
(74) Representative: Fish & Richardson P.C.

(56) References cited:
- WO-A1-2022/163065
- WO-A2-2006/063081
- US-A1- 2021 111 025
- US-A1- 2024 096 774

## Description

### Technical Field

The present disclosure relates to a method of improving the adhesion strength of metal-organic interfaces in an electronic device.

### Background

The fabrication process of electronic (or photonic) devices is composed of many sequential steps to produce circuits on a wafer or a panel (collectively referred to herein as a substrate) of a material (e.g., semiconductor wafers, glass panels, printed circuit board, organic/ceramic substrates, etc.). Defects of any source introduced during the fabrication process reduces yield of the resulting devices. One cause of defects results from inadequate adhesion at metal-organic interfaces of the device. An electronic device (e.g., package substrate, integrated circuit chip, optoelectronic devices, etc.) includes numerous metal-organic interfaces. Adhesion between the metal component (e.g., interconnect, landing pad, via, etc.) and the organic component (e.g., dielectric material, molding compound, underfill material, etc.) at a metal-organic interface may be compromised for many reasons. For example, the quality/structure of the materials at the interface, embedded particles/residue on the interface (debris, chemicals, etc.), high thermomechanical interfacial forces (e.g., due to CTE mismatch), etc. Poor adhesion between the metal (e.g., copper pad) and the organic (e.g., dielectric) at an interface may introduce defects (e.g., delamination, cracks, etc.) at the interface and lead to reduced yield and/or reliability of the device. A strong metal-organic interface ensures that downstream processes (e.g., chemicals and/or process conditions used during downstream processes) do not deteriorate the adhesion strength of interface. Moreover, miniaturization of electronic devices requires miniaturization of integrated-circuit (IC) substrates (e.g., Printed Circuit Board (PCB)) consisting of layers of organic material (commonly referred to as build-up layers or dielectric layers comprising, for example, polymers, build up layers, e.g., Ajinomoto Build-up Film (ABF), etc.) and metal (e.g., copper) interconnect circuitry (e.g., lines, planes, vias, etc.). To manufacture very fine copper circuitry with small line and space widths for next generation electronic devices, the adhesion between the copper and dielectric layer needs to be increased.

Current adhesion improvement methods rely on surface roughening a metal surface to allow an overlapping dielectric layer to mechanically interlock with the metal surface and improve adhesion. For example, the surface of the metal interconnect is modified by, for example, etching, plasma ablation, etc. prior to depositing the dielectric layer to improve the adhesion between the metal and dielectric. However, such surface roughening may detrimentally affect the electrical performance of the electronic device and/or result in reliability issues. For example, highfrequency applications may require a low surface roughness, etching/ablation may require additional cleaning steps and/or cause debris from the roughening process to redeposit and be embedded on the interface. The methods of improving adhesion of the current disclosure may alleviate at least some of the above-described deficiencies. However, the scope of the current disclosure is defined by the claims and not by the ability to solve any problem.

WO 2022/163065 A1 describes a method for producing a layered body including: a step A for preparing a first layered body by layering a first resin film and a patterned metal layer; a step B for preparing a second resin film having indentations corresponding to the metal layer pattern; and a step C for mating the metal layer pattern and the indentations in the second resin film and bonding together the first layered body and second resin film.

WO 2006/063081 A2 describes miniature circuitry and inductor components in which multiple levels of printed circuitry are formed on each side of a support panel, typically a printed circuit board or rigid flex. Electrical connection between the plural levels of circuitry and multiple windings around magnetic members are provided by plural plated through hole conductors. Small through hole openings accommodate a plurality of the plated through hole conductors since each is insulated from the others by a very thin layer of vacuum deposited organic layer such as parylene having a high dielectric strength. Adhesion of this plated copper to the organic layer is provided by first applying an adhesive promotor to the surface of the organic layer followed by the vacuum deposition of the organic layer.

US 2021/111025 A1 describes methods of forming structures including a photoresist underlayer and structures including the photoresist underlayer. Exemplary methods include forming the photoresist underlayer that includes metal. Techniques for treating a surface of the photoresist underlayer and/or depositing an additional layer overlying the photoresist underlayer are also described.

Embodiments of a method for improving the interfacial strength of metal-organic interfaces of an electronic device are disclosed. The invention is defined in the appended claims.

### BRIEF DESCRIPTION OF THE DRAWINGS

The accompanying drawings, which are incorporated herein and constitute a part of this disclosure, illustrate exemplary embodiments and, together with the description, are used to explain the disclosed principles. In these drawings, where appropriate, reference numerals that illustrate the same or similar structures, components, materials, and/or elements in different figures are labeled similarly. It is understood that various combinations of the structures, components, and/or elements, other than those specifically shown, are contemplated and are within the scope of the present disclosure.

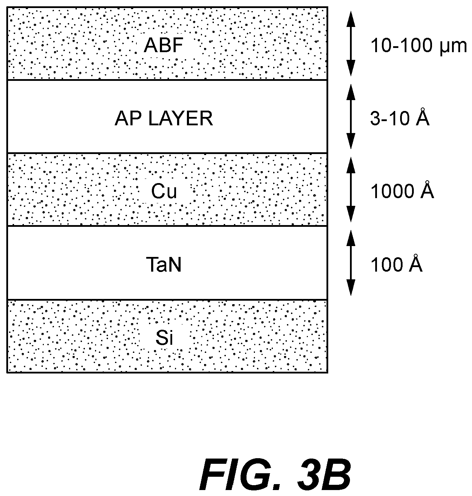

For simplicity and clarity of illustration, the figures depict the general structure of the various described embodiments. Details of well-known components or features may be omitted to avoid obscuring other features, since these omitted features are well-known to those of ordinary skill in the art. Further, features in the figures are not necessarily drawn to scale. The dimensions of some features may be exaggerated relative to other features (for example, see Fig. 3B) to improve understanding of the exemplary embodiments. One skilled in the art would appreciate that the features in the figures are not necessarily drawn to scale and, unless indicated otherwise, should not be viewed as representing dimensions or proportional relationships between different features in a figure. Additionally, even if it is not expressly mentioned, aspects described with reference to one embodiment or figure may also be applicable to, and may be used with, other embodiments or figures.
Fig. 1A is a simplified schematic illustration of a metal-organic interface in an electronic device;
Fig. 1B is a schematic cross-sectional view of an exemplary electronic device that includes the interface of Fig. 1A;
Fig. 2A is a flow chart of an exemplary method of treating the metal surface in the metal-organic interface of Fig. 1A;
Fig. 2B is a flow chart of another exemplary method of treating the metal surface in the metal-organic interface of Fig. 1A;
Fig. 3A shows the results of experiments conducted on samples representing exemplary embodiments of the current disclosure; and
Fig. 3B is a schematic representation of the structure of the samples in the tests of Fig. 3A.

### DETAILED DESCRIPTION

All relative terms such as "about," "substantially," "approximately," etc., indicate a possible variation of ±10% (unless noted otherwise or another degree of variation is specified). For example, a feature disclosed as being about "t" units thick (or length, width, depth, etc.) may vary in thickness from (t-0.1t) to (t+0.1t) units. In some cases, the specification also provides context to some of the relative terms used. For example, a structure (e.g., a coating edge) described as being substantially flat may deviate by ±10% from being perfectly flat. Further, a range described as varying from, or between, 5 to 10 (5-10), includes the endpoints (i.e., 5 and 10). Moreover, as used herein, a composition that includes at least one of A, B, or C is used to refer to a composition that includes one or more of A, B, or C. For example, a composition that includes only A, a composition that includes only B, a composition that includes only C, a composition that includes both A and B, a composition that includes both A and C, a composition that includes A, B, and C, etc.

Unless otherwise defined, all terms of art, notations, and other scientific terms or terminology used herein have the same meaning as commonly understood by persons of ordinary skill in the art to which this disclosure belongs. Some components, structures, and/or processes described or referenced herein are well understood and commonly employed using conventional methodology by those skilled in the art. These components, structures, and processes will not be described in detail. All patents, applications, published applications and other publications referred to herein as being incorporated by reference are incorporated by reference in their entirety. If a definition or description set forth in this disclosure is contrary to, or otherwise inconsistent with, a definition and/or description in these references, the definition and/or description set forth in this disclosure controls over those in references incorporated by reference. None of the references described or referenced herein is admitted as prior art relative to the current disclosure. It should be noted that, in this disclosure, the term "electronic device" is used to cover all components and electronic/photonic assemblies (e.g., package substrate, printed circuit board, interposer, integrated circuit chip, etc.).

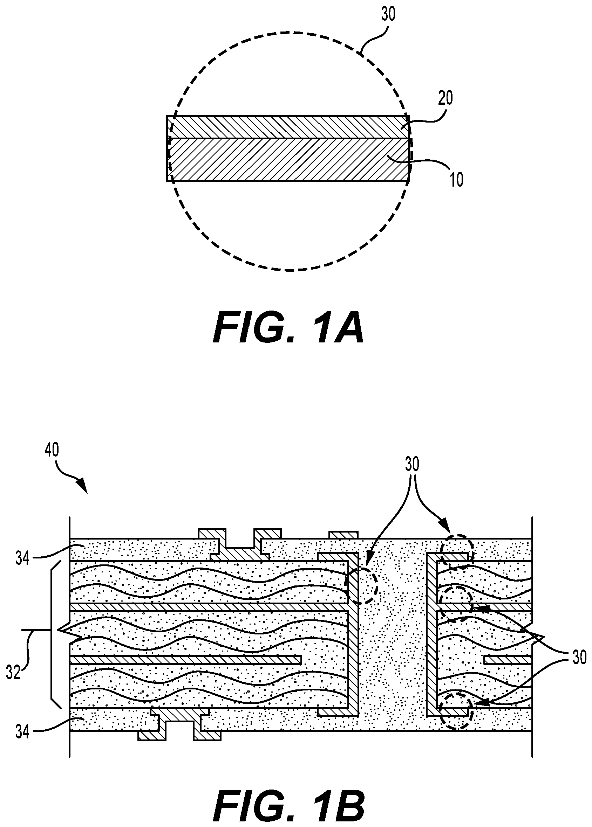

The discussion below describes an exemplary method to improve the interfacial adhesion strength of a metal-organic interface in an electronic device. Fig. 1A is a simplified representation of a metal-organic interface 30 of an exemplary electronic device illustrated in Fig. 1B. Interface 30 includes a metal structure 10 (e.g., line, plane, pad, via wall, etc.) with an organic layer 20 formed on one of its surfaces. Organic layer 20 may be formed on metal structure 10 by any known method used in the fabrication of electronic devices (e.g., deposition, plating, growing, spraying, etc.). In an exemplary embodiment, metal-organic interface 30 of Fig. 1A may an interface of an exemplary package substrate 40 that represents the electronic device of Fig. 1B. Packaged substrate 40 is an 8 layer High Density Interconnect (HDI) substrate with two build-up layers 34 on each side of core stack 32 having 4 circuit layers (referred to as a 2+4+2 (2 build-up + 4 core layers + 2 build-up layers) stack). The core stack 32 may be made of a BT (bismaleimide triazine) epoxy with embedded glass fibers that separate the copper interconnect lines and plated through hole (PTH) vias of the core. The build-up layers 34 on either side of the core stack 32 may also include an organic dielectric material (such as ABF) that separate the copper interconnect structures (e.g., interconnect lines, inter-layer vias, bond pads, etc.) in these layers. In some embodiments, the BT epoxy core stack 32 may be fabricated first and then build-up layers 34 may be sequentially formed (e.g., by depositing, photo-lithographic patterning, etching, etc.) and on the top and bottom. As illustrated by the dashed line circles in Figs. 1A and 1B, the metal-organic interface 30 of Fig. 1A may be an interface located anywhere on package substrate 40. Although interface 30 is described as being part of a package substrate 40, as explained previously, the interface 30 can be a part of any electronic device. For example, on the back end structure of an IC die, etc.

In the embodiment illustrated in Figs. 1A and 1B, the material of metal structure 10 is the electrically conductive interconnect material (e.g., copper, etc.). The material of organic layer 20 depends on the location of interface 30 in package substrate 40. For example, if interface 30 is an interface in the core stack 32, organic layer 20 may be an organic material used in the core (e.g., BT epoxy, etc.). And if interface 30 is an interface in a build-up layer 34, organic layer 20 may be an organic material used in the build-up layer (e.g., ABF, or any other build-up material etc.). These materials are only exemplary. In general, organic layer 20 may include any material such as, for example, polymer, dielectric, epoxy (e.g., underfill epoxy, over mold epoxy, etc.), or a composite material consisting of two or more of the above materials. For example, a composite of glass fiber, epoxy resign and silica filler material with a layer of copper on top, commonly called copper clad laminate, etc. And, metal structure 10 may include any metal or alloy, such as, for example, copper, gold, titanium, aluminum, etc. Moreover, metal structure 10 of interface 30 may be any portion of the interconnect structure (e.g., interconnect line, power plane, ground plane, inter-layer via, PTH, bond pad, etc.) on package substrate 40.

With reference to Fig. 1A, in the methods of the current disclosure, after the metal structure 10 is formed by any suitable method, prior to forming the organic layer 20 on a surface of the metal structure 10 (e.g., by depositing a layer of the organic material), a thin layer that is a mono-layer of a suitable silane is formed (e.g., deposited) on the surface of the metal structure 10 to increase the adhesion of the organic layer 20 on the metal structure 10. Metal structure 10 may be formed by any process (e.g., IC fabrication process) used to form metal structures on an underlying substrate. For example, one exemplary process of forming metal structure 10 on an underlying substrate (e.g., core stack 32 of Fig. 1B) may include depositing (e.g., by chemical vapor deposition (CVD), etc.) a layer of a metal (e.g., copper) on the substrate and patterning the metal layer into the desired circuit pattern using conventional photolithographic processes. The organic layer 20 may also be formed atop the metal structure 10 by any known process (e.g., deposition, plating, spraying, etc.) used in the fabrication of package substrate 40. Prior to forming the organic layer 20, a silane mono-layer is formed (e.g., deposited) on the surface of the metal structure by vapor phase silane deposition. In general, the deposited silane mono-layer may be about 0.1-3 nm (1-30 Angstroms) thick. In some embodiments, the silane mono-layer may be between about 0.1-1 nm (1-10 Angstroms) thick. It should be noted that that the "thickness" of a mono-layer may be the length of the silane molecule. The coverage of the mono-layer on the substrate may not be 100% and if a measurement technique such as ellipsometry is used to measure the "thickness" of such a film, the derived thickness may be between 0-100% of the length of the molecule, depending on the percentage coverage of the mono-layer on the substrate.

Vapor phase silane deposition is a controlled process that provides a stable environment for forming a uniform self-assembled mono-layer silane coating on the surface of the metal structure 10. Functionalized silane mono-layer coatings provide reactivity and functionality to the surface of the metal structure 10 by creating a durable and covalent bond between the silane molecules and the underlying metal structure 10. As known to persons skilled in the art, the physical and chemical properties of a solid surface are largely determined by the outmost layer of atoms or chemical groups. As a result, coating the surface of metal structure 10 with a suitable silane mono-layer allows the metal structure 10 to form a strong bond with the molecules of the organic layer 20 that will be deposited (or otherwise formed) thereon. Although silane surface modification of metal surfaces is known (*see,* e.g., Sagiv; J. Am. Chem. Soc.; January 1, 1980; 102; pp. 92-98), successful silane coupling agents for metals that form hydrolytically or mechanically unstable surfaces oxides were not previously disclosed. Suitable silane coupling agents for bonding between a metal surface and an organic layer have also not been previously disclosed.

Suitable silane coupling agents to increase the adhesion strength of metal-organic interfaces may include a class of aminosilanes with at least one primary or secondary amine group, and at least one alkoxysilyl group. The alkoxysilyl group may be one of - ethoxy, methoxy, butoxy, propoxy, or isopropoxy. And, the alkoxysilyl group may have between one and three alkoxy groups attached. Suitable silane coupling agents of the current disclosure may also include a class of thiol containing silanes including at least one thiol (S-H) group and at least one alkoxysilyl group. Suitable silane coupling agents of the current disclosure may further include a class of thiocyanate containing silanes having at least one thiocyanate group (S≡N) and at least one alkoxysilyl group. In some embodiments, the selected silane composition may have a boiling point below about 250°C at a pressure between about 0.1-10 Torr.

Table 1 lists the silane compositions that may be used as effective coupling agents for metal-organic interfaces (interface 30 of Fig. 1A). These compositions may be especially suitable to increase the adhesion of organic build-up materials (such as, for example, ABF) to surfaces of metal structures 10 formed by different processes, such as, for example, electroless copper, physical vapor deposited (PVD) Copper, electroplated copper, electroplated gold, PVD gold, etc. Furthermore, in some embodiments, the selected silane composition may have a boiling point below about 250°C at a pressure between about 0.1-10 Torr.

**Table 1: Exemplary silane chemistries.**

| | | |
|---|---|---|
| 1 | N-(2-Aminoethyl)-3-aminopropyltrimethoxysilane (AE-APTMS), CAS# [1760-24-3] | 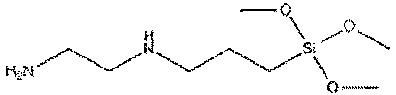 |
| 2 | N,N'-Bis[(3-trimethoxysilyl)propyl] ethylenediamine (TMSP-ED), CAS# [68845-16-9] | 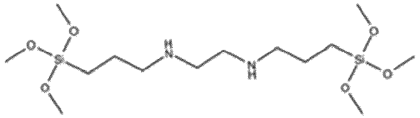 |
| 3 | Bis(3-Trimethoxysilylpropyl)amine, (TMSPA) CAS# [82985-35-1] | 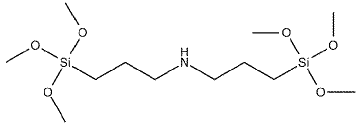 |
| 4 | 3-Mercaptopropyltrimethoxysilane (MPT MS), CAS# [4420-74-0] | 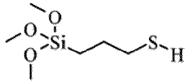 |
| 5 | N-(2-Aminoethyl)-3-aminopropylsilanetriol, 25% in water (AE-APST), CAS# [68400-09-9] | 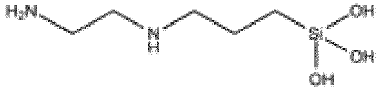 |
| 6 | 3-Thiocyanatopropyltriethoxysilane, 92% (TCPTES), CAS# [34708-08-2] | 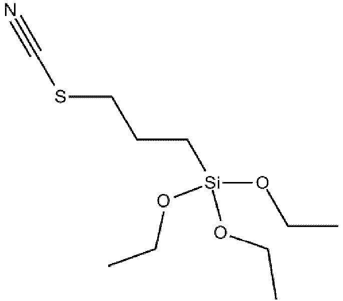 |
| 7 | N-(6-Aminohexyl)aminomethyl trimethoxysilane, CAS# [15129-36-9] | 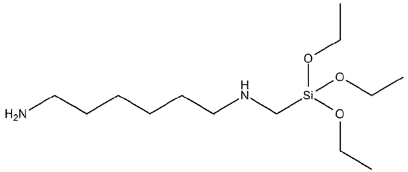 |
| 8 | N-(6-Aminohexyl)aminopropyl trimethoxysilane, CAS # [51895-58-0] | 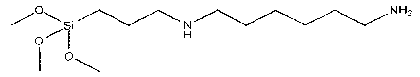 |
| 9 | 1,3-Bis(3-aminopropyl)tetramethyldisiloxane, CAS # [2469-55-8] | 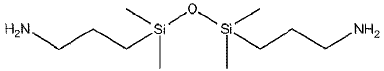 |
| 10 | Bis[3-(triethoxysilyl)propyl]disulfide, 90% (TESPDS), CAS# [56706-10-6] | 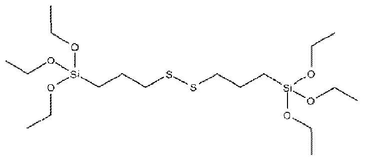 |
| 11 | Aminoethylaminopropyl/methylsilsesq uioxane, in aqueous solution (AEAPMS) | 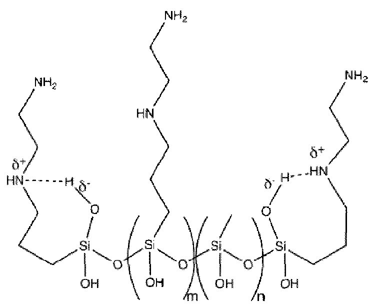 |
| 12 | Aminopropylsilsesquioxane in aqueous solution (APS) | 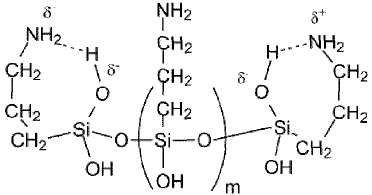 |
| 13 | (2-Diethylphosphatoethyltriethoxysilane), CAS # 757-44-8 | 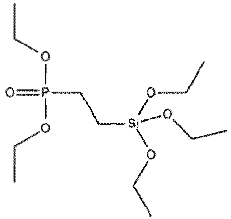 |
| 14 | (2-Diethylphosphatoethyl)methyldiethoxy silane, CAS # SID3411.0 | 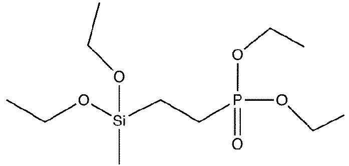 |
| 15 | N-(2-Aminoethyl)-3-Aminopropyltriethoxysilane | 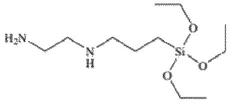 |
| 16 | 3-(M-AMINOPHENOXY)PROPYLTRIMET HOXYSILANE | 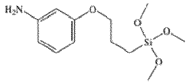 |
| 17 | N-(2-Aminoethyl)-3-Aminopropylmethyldimethoxysilane | 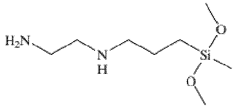 |
| 18 | N-(2-Aminoethyl)-3-Aminoisobutylmethyldimethoxysilane | 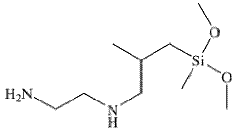 |
| 19 | N-(2-Aminoethyl)-3-Aminoisobutyldimethylmethoxysilane | 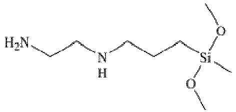 |
| 20 | 4-Aminobutyltriethoxysilane | 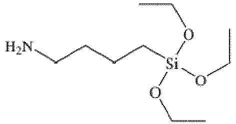 |
| 21 | (Aminoethylaminomethyl)Phenethyltrimethoxysilane | 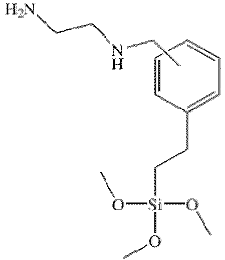 |
| 22 | N-(2-Aminoethyl)-3-Aminopropylmethyldiethoxysilane | 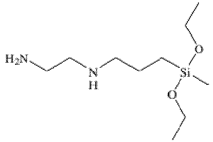 |
| 23 | N-(2-Aminoethyl)-11-Aminoundecyltrimethoxysilane | 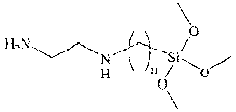 |
| 24 | N-(6-Aminohexyl)Aminopropyltrimethoxysilane | 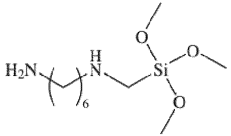 |
| 25 | m-AMINOPHENYLTRIMETHOXYSILANE | 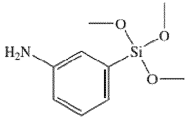 |
| 26 | p-AMINOPHENYLTRIMETHOXYSILANE | 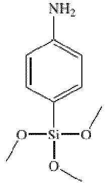 |

It was determined that treating the surfaces of the metal structures 10 using a vapor of at least one of the above-described silane chemistries by depositing a mono-layer of the silane composition by vapor phase silane deposition prior to forming the organic layer 20 thereon increases the adhesion strength of the interface 30. In vapor phase the process works with individual molecules and forms ultrathin mono-layer coatings on the metal structure 10. The above-described silane chemistries listed in Table 1 have been selected such that they will not react head to tail and therefore will not polymerize and form thick layers. With some chemistries, in liquid phase, the chemicals may have a tendency to clump together and form uneven layers. Vapor phase deposition has the additional benefit of being able to diffuse through small openings as device features reduce in size.

The chemistry of the silane composition selected for any particular application depends on the materials that form the interface, process conditions, etc. For example, the materials that constitute the metal structure 10 and organic layer 20, the process conditions, etc. It was determined that these silane chemistries are effective to improve the adhesion of both smooth and rough surfaces and provide good post deposition film stability. Although the disclosed silane chemistries or compositions are expected to be suitable for a wide variety of materials used as metal structures 10 and organic layers 20 in electronic devices, they were determined to be especially effective for increasing the adhesion between organic layers 20 comprising ABF and silicon nitride and metal structures 10 comprising copper. These silane chemistries are also expected to be effective to increase the adhesion strength between any metal with an unstable oxide and a polyamide. It is believed that the functionalized and reactive groups of the disclosed silane chemistries will allow for a variety of bonding mechanisms between the metal structure 10 and the organic layer 20. The formed bonds are expected to anchor between the silane groups and the metal surfaces as well as in plane cross linking which increases mono-layer stability. Although all the above-disclosed silane chemistries are effective to improve the adhesion between metal structure 10 and organic layer 20, for metal structures 10 comprising copper, the preferred amines may include the silane compositions numbered 1, 2, 3, 5, 7, 8, and 9 (in Table 1) and the sulphur-containing preferred compositions may include those numbered 4 and 6 in Table 1.

In the invention, the surface of the metal structure 10 is be treated with one or more of the above-described silane chemistries using a vapor phase silane deposition process. In some embodiments of an exemplary vapor phase silane deposition process, a vapor of the desired silane chemistry is introduced into a process chamber that supports therein a substrate (e.g., package substrate 40 of Fig. 1B) with an exposed metal structure 10. The process chamber of any suitable semiconductor process apparatus may be used for the vapor phase silane deposition process. For example, the process chamber of the process apparatus described in any of U.S. Patent Nos: 7,727,588; 8,252,375; 8,361,548; 10,147,617; 10,319,612; 10,490,431; 11,367,640; 11,444,053; 11,335,662; 11,296,049; 11,456,274; and 11,465,225 may be used. In some embodiments, the temperature and pressure of the vapor in the process chamber may be adjusted to keep the applied silane chemistry in its vapor phase. The exact values (or ranges) of temperature and pressure to keep the silane in its vapor phase depends on the applied silane chemistry and the application (e.g., the materials involved, etc.). In general, the metal structure 10 may be exposed to the silane vapor for any desired time (e.g., from about 3 minutes - 2 hours). In some embodiments, the metal structure 10 may be exposed to the silane vapor for a period or time between about 10-30 mins, or about 15-20 mins. It some embodiments, a longer time may be used. A silane mono-layer may be formed during the initial stages (e.g., first 10-20 mins) of exposure. Increasing the exposure time may increase the density of the formed mono-layer.

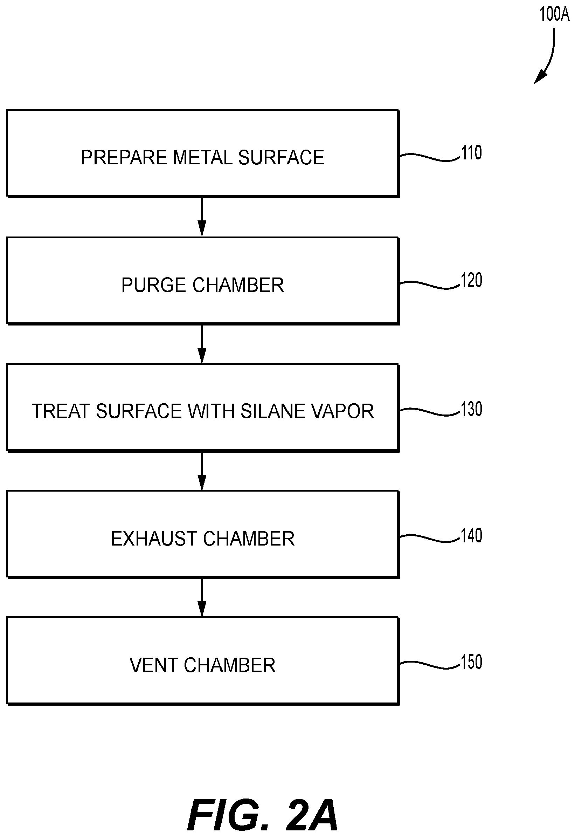

Fig. 2A is a flow chart of an exemplary process 100A that may be used to treat a substrate with the metal structure 10 formed thereon. One or more substrates with the metal structure 10 may be placed in a process chamber. The surface of the metal structure 10 and/or the substrate may be prepared for silane treatment (step 110). In some embodiments, the surface preparation may include a wet process, such as, for example, a dilute acid bath or exposing the surface to a dry active plasma to remove contaminants and native oxide from the surface. The process chamber may then be purged to remove oxygen and moisture (step 120). In some embodiments, as described in more detail in, for example, U.S. Patent Nos 7,727,588 and 8,252,375, the process chamber may be subjected to one or more successive vacuum and nitrogen purge cycles to create a relatively oxygen and moisture free environment in the process chamber. In some embodiments, heated nitrogen gas may be used. For example, in some embodiments, the process chamber may be subject to vacuum (e.g., about 10 Torr for 2 minutes, etc.) and then to room temperature nitrogen gas or heated nitrogen gas (e.g., at 150°C), either once or multiple times to remove moisture and oxygen from the chamber. If heated nitrogen gas is used, the pre-heated nitrogen gas may also warm the surface of the substrate. In embodiments where it is desirable to not heat the substrate before the oxygen level is reduced to be below an acceptable level (e.g., < 100 ppm), room temperature (or cooled) nitrogen gas may be used. Vapor of the desired silane composition (e.g., a composition listed in Table 1) may then be admitted into the process chamber (step 130). The chemical vapor injected into the chamber may be vaporized from a silane solution and then admitted into the process chamber or may be transported via inert carrier gas (such as, e.g., nitrogen). For example, heated nitrogen gas may be bubbled through liquid silane of the desired chemistry and then admitted into the process chamber. In some embodiments, the silane vapor of step 130 may be vaporized from pure liquid chemistry or may be vaporized from a solid or semisolid chemistry. As explained previously, exposure time of the silane vapor to the substrate may be varied depending on the reaction rate of the substrate to achieve a dense mono-layer film. The temperature and pressure of the chamber may also be adjusted to keep the silane chemistry in vapor phase. After the metal structure 10 is exposed to the silane vapor for a sufficient time, the chamber may be evacuated to remove excess chemical vapor from the chamber (step 140). In some embodiments, similar to step 120, the process chamber may be alternately subject to vacuum and nitrogen gas one or more times to completely remove the chemical vapor from the chamber. In some embodiments, the chamber may then be vented to the atmosphere (step 150). After the metal structure 10 is treated with silane vapor, the organic layer 20 may be formed atop the treated metal structure 10 by any suitable process known in the art (e.g., deposition, etc.). In some embodiments, a conformal coating of the organic layer 20 may be deposited on the substrate surface with the metal structure 10.

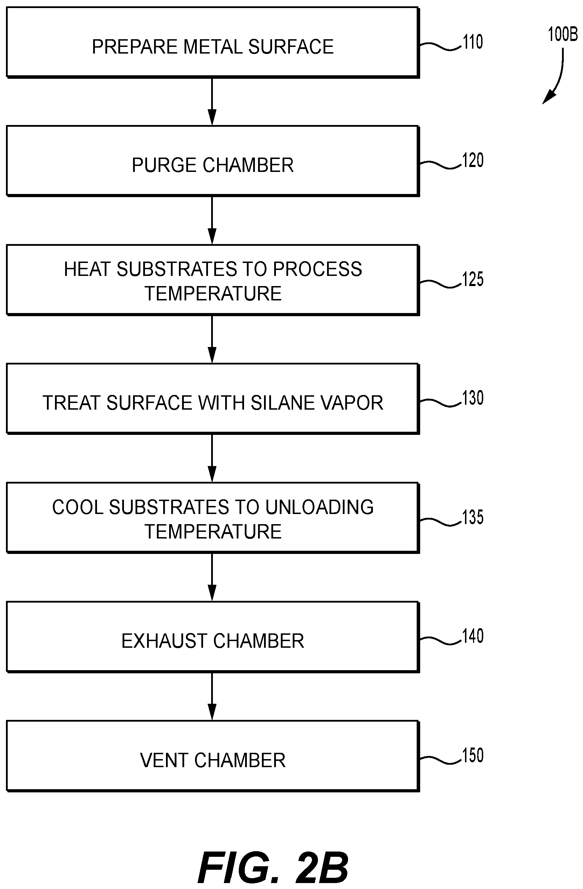

In some embodiments, the process of Fig. 2A may be used in process apparatuses which have a preheated chamber. In other embodiments of process apparatuses, the process chamber and/or the substrate may be heated from room temperature to process temperature before silane treatment (step 130) and then cooled down to a temperature safe for exposure to atmospheric oxygen (typically <100C). Such a process may be used to treat metals (e.g., copper) that are sensitive to oxygen. Fig. 2B is a flow chart of another exemplary process that may be used. Process steps of Fig. 2B that are similar to those described with reference to Fig. 2A are numbered similarly and are not described in detail. In process 100B of Fig. 2B, after purging the chamber (step 120) as described with reference to Fig. 2A, the process chamber and/or the substrates may be heated to the process temperature (step 125). The process temperature (e.g., 150°C, 175°C, 200°C, etc.) may depend on the process apparatus used. The metal surface is then treated with a vapor of the selected silane (step 130). The substrates are then cooled to a safe unloading temperature of, for example, less than about 100°C (step 135). The chamber may then be exhausted (step 140) and vented (step 150). It should be noted that the processes illustrated in Figs. 2A and 2B are only exemplary and many modifications are possible. For example, the described steps may be performed in a different order and some steps may be eliminated. For example, in process 100B of Fig. 2B, steps 135 and 140 may be interchanged (e.g., step 140 may be performed before step 135). In some embodiments, the processes 100A and 100B may be part of a larger process. For example, in some embodiments, process 100A or 100B may be incorporated in a process used to deposit an organic material on the metal structure.

When the metal structure 10 is exposed to the silane vapor in step 130, the silane chemistry may bond to the surface of metal structure 10. Although the silane may bond with the metal structure using any mechanism, in some embodiments where metal structure 10 includes copper, the silane chemistry may bond to the metal structure 10 using one or more of the mechanisms listed in Table 2 below.

**Table 2: Exemplary bonding mechanisms.**

| | | |
|---|---|---|
| A | Hydrogen bonding | 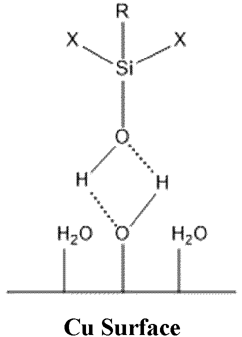 |
| B | Covalent Bonding via surface oxides | 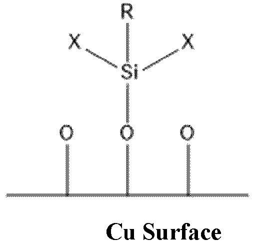 |
| C | Chelation assisted amine bond | 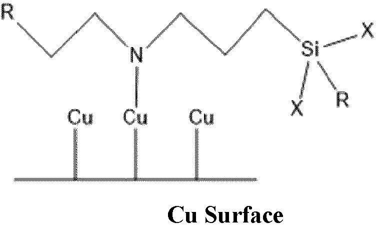 |
| D | Coordination bond | 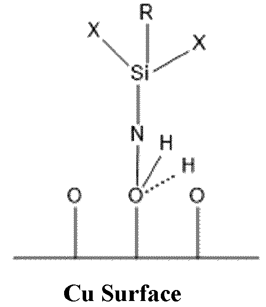 |
| E | Direct Sulfur/ Amine bond | 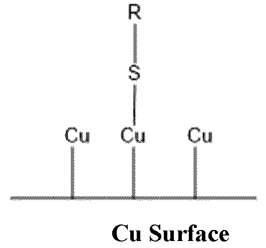 |

The surface of the copper metal structure 10 may be populated with Cu atoms or CuO molecules which result in the different bonding mechanisms as outlined above. The unique feature of the selected silane chemistries is that they can form covalent bonds in areas that are oxidized or chelated bonds in areas where the native oxide has been removed and only copper remains. This "dual functionality" holds whether the selected chemical is an amine or thiol functionality. Orientation of the molecule may change from one point to another on the surface, but the molecule will still bond. In some embodiments, each of these selected molecules will use all of the bonding mechanisms at various places on the surface.

Adhesion tests (peel tests) were conducted to evaluate the effect of treating an exemplary metal structure with exemplary disclosed silane chemistries of Table 1. Tests were conducted using a TMI Peel Tester at a 90° peel angle and a peel rate of 50 mm/min. Table 3 below lists the details of some of the samples tested.

**Table 3: Test samples and test conditions.**

| **Sample name (see** **Fig. 3****)** | **Description of sample** |
|---|---|
| Reference | Blanket sample no adhesion promotion silane treatment |
| Thermal 175C | Blanket sample that underwent thermal process 175C with no silane treatment |
| Thermal 200C | Blanket sample that underwent thermal process 200C with no silane treatment |
| AEAPTMS 175C | Blanket sample that underwent the disclosed silane treatment with silane chemistry 1 of Table 1 |
| TMSP-ED 175C | Blanket sample that underwent the disclosed silane treatment with silane chemistry 2 of Table 1 |

With reference to Table 3, in the sample labeled "AEAPTMS 175C," the process chamber (or the substrates) was heated to about 175°C in a N₂ atmosphere, and after a period of stabilization (typically 2-30 min), the chamber was evacuated to base pressure and AE-APTMS silane vapor (silane chemistry 1 of Table 1) was introduced into the process chamber and the substrate exposed to the vapor for about 90 minutes. Similarly, for the sample labelled "TMSP-ED 175C," the process chamber/substrate was heated to 175°C, and the substrate was treated to the vapor of the silane chemistry 2 of Table 1. For the samples labeled "Thermal 175C" and "Thermal 200C," the substrates were heated to 175°C and 200°C respectively, held at that temperature and cooled without silane treatment. These samples served as control samples to separate the effect of heating the substrates on the surface properties (e.g. by dehydration) from the effect of silane reaction with the substrate surface. The "Reference" samples were not subject to a thermal process or to silane treatment and served as control samples. The test included samples with the copper layer formed by CCL (Copper Clad Laminate) and samples with the copper layer formed by PVD (Physical Vapor Deposition) to determine the effect of the silane composition on the surface of copper layers formed by different methods (e.g., CCL Cu and PVD Cu).

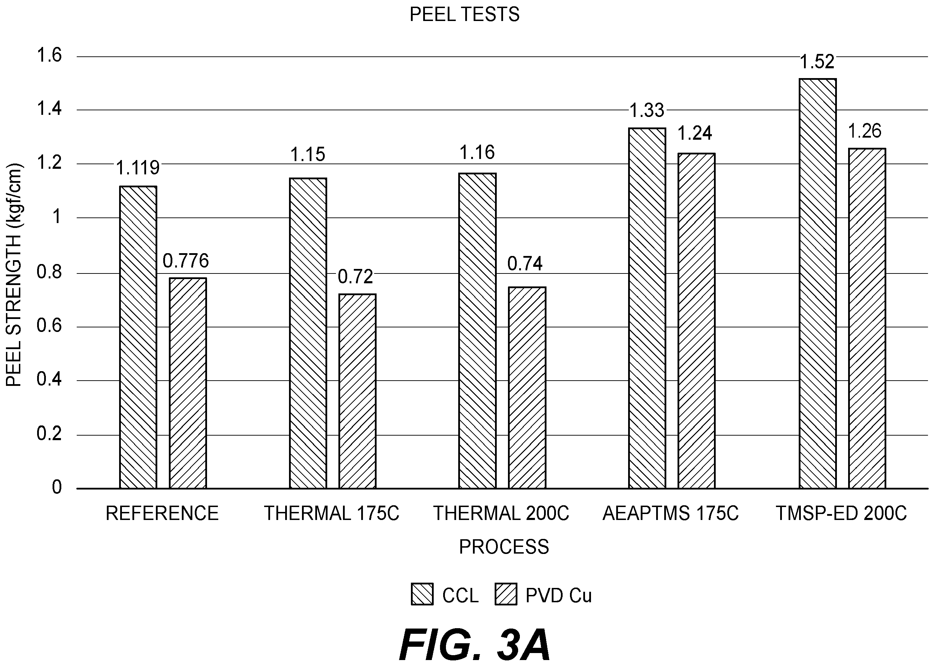

Fig. 3A summarizes the results of the peels tests, and Fig. 3B schematically illustrates the cross-sectional structure of the tested samples. In these samples, the interface tested was the copper-ABF interface. As seen in Fig. 3A, peel testing data shows successful adhesion promotion of ABF on both CCL Cu and PVD Cu surfaces. For example, comparison of the test results of the silane treated samples (e.g., "AEAPTMS 175C" and "TMSP-ED 175C" samples) with unprocessed samples (e.g., "Reference" sample) and thermally processed samples (e.g., "Thermal 175C" and "Thermal 200C" samples) indicate that the adhesion strength of the metal-organic interface increases as a result of the silane treatment. Failure analysis of the samples after testing confirms predictions and indicates that the silane treated samples failed by cohesive failure in the ABF layer while the samples that did not undergo silane treatment experienced adhesive failure at the copper-ABF interface thereby confirming the effectiveness of the disclosed silane treatment for improving adhesion. Although only the results of samples treated using silane chemistries 1 and 2 (of Table 1) on the copper surface of a Cu-ABF interface are described herein, predictions (e.g., based on the structure and chemistry of the listed silane compositions, the metal, the organic, etc.) indicate that all the above-described silane chemistries are expected to be effective in improving the adhesion of copper structures to other organic materials (build-up layers, dielectric layers, etc.) used in electronic devices.

Treating the surface of the metal structures 10 using the disclosed processes may increase the adhesion between the metal structure 10 and the organic layer 20 in an electronic device. This improvement in adhesion may result in the reduction of (or the elimination of) post etch delamination from the top and sidewalls of metal-organic interfaces that cause interfacial failure and reliability issues in electronic devices. Since the increase in adhesion is achieved without increasing the surface roughness of the metal structure 10, signal loss may also be eliminated.

The methods of the invention may be used for adhesion promotion of metal-organic interfaces in electronic devices used, for example, in drug delivery, drug absorption, gas separation, lithium-ion batteries, CO₂ Capture, medical sensors, biological markers, wearable devices, etc. The disclosed silane treatment methods may be incorporated in any suitable process apparatus (e.g., process oven, vapor deposition systems, coating machines, etc.) Furthermore, although in the description above, some process steps were disclosed with reference to specific embodiments, a person skilled in the art would recognize that this is only exemplary, and these steps are applicable to all disclosed embodiments. Other embodiments of the disclosed methods will be apparent to those skilled in the art from consideration of the disclosure herein

## Claims

1. A method of improving the adhesion of a metal-organic interface in an electronic device, comprising:
providing a substrate with a metal structure formed thereon;
treating a surface of the metal structure with a vapor of a silane composition, wherein the silane composition includes at least one of
(i.) N-(2-Aminoethyl)-3-aminopropyltrimethoxysilane (AE-APTMS),
(ii.) N,N'-Bis[(3-trimethoxysilyl)propyl] ethylenediamine (TMSP-ED),
(iii.) Bis(3-Trimethoxysilylpropyl)amine, (TMSPA),
(iv.) 3-Mercaptopropyltrimethoxysilane (MPTMS),
(v.) N-(2-Aminoethyl)-3-aminopropylsilanetriol, 25% in water (AE-APST),
(vi.) 3-Thiocyanatopropyltriethoxysilane, 92% (TCPTES),
(vii.) N-(6-Aminohexyl)aminomethyltriethoxysilane,
(viii.) N-(6-Aminohexyl)aminopropyltrimethoxysilane,
(ix.) 1,3-Bis(3-aminopropyl)tetramethyldisiloxane,
(x.) Bis[3-(triethoxysilyl)propyl]disulfide, 90% (TESPDS),
(xi.) Aminoethylaminopropyl/methylsilsesquioxane, in aqueous solution,
(xii.) Aminopropylsilsesquioxane in aqueous solution (APS),
(xiii.) (2-Diethylphosphatoethyltriethoxysilane),
(xiv.) (2-Diethylphosphatoethyl)methyldiethoxysilane,
(xv.) N-(2-Aminoethyl)-3-Aminopropyltriethoxysilane,
(xvi.) 3-(m-Aminophenoxy)propyltrimethoxysilane,
(xvii.) N-(2-Aminoethyl)-3-Aminopropylmethyldimethoxysilane,
(xviii.) N-(2-Aminoethyl)-3-Aminoisobutylmethyldimethoxysilane,
(xix.) N-(2-Aminoethyl)-3-Aminoisobutyldimethylmethoxysilane,
(xx.) 4-Aminobutyltriethoxysilane,
(xxi.) (Aminoethylaminomethyl)Phenethyltrimethoxysilane,
(xxii.) N-(2-Aminoethyl)-3-Aminopropylmethyldiethoxysilane,
(xxiii.) N-(2-Aminoethyl)-11-Aminoundecyltrimethoxysilane,
(xxiv.) N-(6-Aminohexyl)Aminomethyltrimethoxysilane,
(xxv.) m-Aminophenyltrimethoxysilane, or
(xxvi.) p-Aminophenyltrimethoxysilane,
and after treating the surface, coating the treated surface with an organic material;
**characterized in that** treating the surface of the metal structure includes depositing a mono-layer of the silane composition on the treated surface.

2. The method of claim 1, wherein the silane composition includes at least one of
(ii.) N,N'-Bis[(3-trimethoxysilyl)propyl] ethylenediamine (TMSP-ED),
(iii.) Bis(3-Trimethoxysilylpropyl)amine, (TMSPA),
(v.) N-(2-Aminoethyl)-3-aminopropylsilanetriol, 25% in water (AE-APST),
(vi.) 3-Thiocyanatopropyltriethoxysilane, 92% (TCPTES),
(viii.) N-(6-Aminohexyl)aminopropyltrimethoxysilane,
(ix.) 1,3-Bis(3-aminopropyl)tetramethyldisiloxane,
(x.) Bis[3-(triethoxysilyl)propyl]disulfide, 90% (TESPDS),
(xi.) Aminoethylaminopropyl/methylsilsesquioxane, in aqueous solution,
(xii.) Aminopropylsilsesquioxane in aqueous solution (APS),
(xiii.) (2-Diethylphosphatoethyltriethoxysilane),
(xiv.) (2-Diethylphosphatoethyl)methyldiethoxysilane,
(xvi.) 3-(m-Aminophenoxy)propyltrimethoxysilane,
(xviii.) N-(2-Aminoethyl)-3-Aminoisobutylmethyldimethoxysilane,
(xix.) N-(2-Aminoethyl)-3-Aminoisobutyldimethylmethoxysilane,
(xx.) 4-Aminobutyltriethoxysilane,
(xxi.) (Aminoethylaminomethyl)Phenethyltrimethoxysilane,
(xxiii.) N-(2-Aminoethyl)-11-Aminoundecyltrimethoxysilane, or
(xxiv.) N-(6-Aminohexyl)Aminomethyltrimethoxysilane,

3. The method of claim 1, wherein the silane composition includes at least one of
(ii.) N,N'-Bis[(3-trimethoxysilyl)propyl] ethylenediamine (TMSP-ED),
(iii.) Bis(3-Trimethoxysilylpropyl)amine, (TMSPA),
(v.) N-(2-Aminoethyl)-3-aminopropylsilanetriol, 25% in water (AE-APST),
(xxiv.) N-(6-Aminohexyl)aminomethyltrimethoxysilane,
(viii.) N-(6-Aminohexyl)aminopropyltrimethoxysilane, or
(ix.) 1,3-Bis(3-aminopropyl)tetramethyldisiloxane.

4. The method of claim 1, wherein the mono-layer is about 0.1 to 1 nm thick.

5. The method of claim 1, wherein the silane composition has a boiling point below about 250°C at a pressure between about 13-1300 Pa.

6. The method of claim 1, wherein providing the substrate includes providing the substrate in a process chamber, and the method further includes
purging the process chamber of oxygen or moisture prior to treating the surface with the vapor of the silane composition, and
purging the process chamber of the vapor of the silane composition after treating the surface with the vapor of the silane composition.

7. The method of claim 1, wherein the metal structure includes copper, optionally wherein the organic material includes ABF.

8. The method of claim 1, wherein the substrate is a part of a package substrate.

9. The method of claim 1, wherein the metal structure is an interconnect structure of the electronic device, optionally wherein the interconnect structure is one of an interconnect line, a power plane, a ground plane, a via, or a plated through hole.

10. The method of claim 1, wherein the metal structure is a copper interconnect structure;
wherein the vapor of the silane composition has a boiling point below about 250°C at a pressure between about 13-1300 Pa; and
wherein the organic material is ABF.

11. The method of claim 10, wherein the substrate is a part of a package substrate and the copper interconnect structure is one of an interconnect line, a power plane, a ground plane, a via, or a plated through hole.

12. The method of claim 10, wherein the silane composition includes (ii.) N,N'-Bis[(3-trimethoxysilyl)propyl] ethylenediamine (TMSP-ED).

13. The method of claim 1, wherein the metal structure is a copper interconnect structure;
wherein the silane composition includes (a) at least a primary amine group or a secondary amine group and at least one alkoxysilyl group, (b) the alkoxysilyl group may be one of ethoxy, methoxy, butoxy, propoxy, or isopropoxy, (c) the alkoxysilyl group may have between one and three alkoxy groups attached, and (d) a boiling point below about 250°C at a pressure between about 13-1330 Pa; and
wherein coating the treated surface with an organic material includes depositing ABF on the surface of the copper interconnect structure after depositing the mono-layer of the silane composition.

14. The method of claim 13, wherein the silane composition includes at least one of
(iii.) Bis(3-Trimethoxysilylpropyl)amine, (TMSPA), or
(xxiv.) N-(6-Aminohexyl)aminomethyltrimethoxysilane.

## Patentansprüche

1. Verfahren zum Verbessern der Haftung einer metallorganischen Grenzfläche in einer elektronischen Vorrichtung, umfassend:
Bereitstellen eines Substrats mit einer darauf gebildeten Metallstruktur;
Behandeln einer Oberfläche der Metallstruktur mit einem Dampf einer Silan-Zusammensetzung, wobei die Silan-Zusammensetzung mindestens einen der folgenden Stoffe beinhaltet
(i.) N-(2-Aminoethyl)-3-aminopropyltrimethoxysilan (AE-APTMS),
(ii.) N,N'-Bis-[(3-trimethoxysilyl)propyl]ethylendiamin (TMSP-ED),
(iii.) Bis-(3-trimethoxysilylpropyl)amin (TMSPA),
(iv.) 3-Mercaptopropyltrimethoxysilan (MPTMS),
(v.) N-(2-Aminoethyl)-3-aminopropylsilantriol, 25 % in Wasser, (AE-APST),
(vi.) 3-Thiocyanatopropyltriethoxysilan, 92 %, (TCPTES),
(vii.) N-(6-Aminohexyl)aminomethyltriethoxysilan,
(viii.) N-(6-Aminohexyl)aminopropyltrimethoxysilan,
(ix.) 1,3-Bis-(3-aminopropyl)tetramethyldisiloxan,
(x.) Bis-[3-(triethoxysilyl)propyl]disulfid, 90 %, (TESPDS),
(xi.) Aminoethylaminopropyl-/Methylsilsesquioxan, in wässriger Lösung,
(xii.) Aminopropylsilsesquioxan, in wässriger Lösung, (APS),
(xiii.) (2-Diethylphosphatoethyl)triethoxysilan,
(xiv.) (2-Diethylphosphatoethyl)methyldiethoxysilan,
(xv.) N-(2-Aminoethyl)-3-aminopropyltriethoxysilan,
(xvi.) 3-(m-Aminophenoxy)propyltrimethoxysilan,
(xvii.) N-(2-Aminoethyl)-3-aminopropylmethyldimethoxysilan,
(xviii.) N-(2-Aminoethyl)-3-aminoisobutylmethyldimethoxysilan,
(xix.) N-(2-Aminoethyl)-3-aminoisobutyldimethylmethoxysilan,
(xx.) 4-Aminobutyltriethoxysilan,
(xxi.) (Aminoethylaminomethyl)phenethyltrimethoxysilan,
(xxii.) N-(2-Aminoethyl)-3-aminopropylmethyldiethoxysilan,
(xxiii.) N-(2-Aminoethyl)-11-aminoundecyltrimethoxysilan,
(xxiv.) N-(6-Aminohexyl)aminomethyltrimethoxysilan,
(xxv.) m-Aminophenyltrimethoxysilan oder
(xxvi.) p-Aminophenyltrimethoxysilan,
und nach Behandeln der Oberfläche Beschichten der behandelten Oberfläche mit einem organischen Material; **dadurch gekennzeichnet, dass**
Behandeln der Oberfläche der Metallstruktur Abscheiden einer Monoschicht der Silan-Zusammensetzung auf der behandelten Oberfläche beinhaltet.

2. Verfahren nach Anspruch 1, wobei die Silan-Zusammensetzung mindestens einen der folgenden Stoffe beinhaltet
(ii.) N,N'-Bis-[(3-trimethoxysilyl)propyl]ethylendiamin (TMSP-ED),
(iii.) Bis-(3-trimethoxysilylpropyl)amin (TMSPA),
(v.) N-(2-Aminoethyl)-3-aminopropylsilantriol, 25 % in Wasser, (AE-APST),
(vi.) 3-Thiocyanatopropyltriethoxysilan, 92 %, (TCPTES),
(viii.) N-(6-Aminohexyl)aminopropyltrimethoxysilan,
(ix.) 1,3-Bis-(3-aminopropyl)tetramethyldisiloxan,
(x.) Bis-[3-(triethoxysilyl)propyl]disulfid, 90 %, (TESPDS),
(xi.) Aminoethylaminopropyl-/Methylsilsesquioxan, in wässriger Lösung,
(xii.) Aminopropylsilsesquioxan, in wässriger Lösung, (APS),
(xiii.) (2-Diethylphosphatoethyl)triethoxysilan,
(xiv.) (2-Diethylphosphatoethyl)methyldiethoxysilan,
(xvi.) 3-(m-Aminophenoxy)propyltrimethoxysilan,
(xviii.) N-(2-Aminoethyl)-3-aminoisobutylmethyldimethoxysilan,
(xix.) N-(2-Aminoethyl)-3-aminoisobutyldimethylmethoxysilan,
(xx.) 4-Aminobutyltriethoxysilan,
(xxi.) (Aminoethylaminomethyl)phenethyltrimethoxysilan,
(xxiii.) N-(2-Aminoethyl)-11-aminoundecyltrimethoxysilan oder
(xxiv.) N-(6-Aminohexyl)aminomethyltrimethoxysilan.

3. Verfahren nach Anspruch 1, wobei die Silan-Zusammensetzung mindestens einen der folgenden Stoffe beinhaltet
(ii.) N,N'-Bis-[(3-trimethoxysilyl)propyl]ethylendiamin (TMSP-ED),
(iii.) Bis-(3-trimethoxysilylpropyl)amin (TMSPA),
(v.) N-(2-Aminoethyl)-3-aminopropylsilantriol, 25 % in Wasser, (AE-APST),
(xxiv.) N-(6-Aminohexyl)aminomethyltrimethoxysilan,
(viii.) N-(6-Aminohexyl)aminopropyltrimethoxysilan oder
(ix.) 1,3-Bis-(3-aminopropyl)tetramethyldisiloxan.

4. Verfahren nach Anspruch 1, wobei die Monoschicht etwa 0,1 bis 1 nm dick ist.

5. Verfahren nach Anspruch 1, wobei die Silan-Zusammensetzung einen Siedepunkt unter etwa 250 °C bei einem Druck zwischen etwa 13 und 1300 Pa aufweist.

6. Verfahren nach Anspruch 1, wobei Bereitstellen des Substrats Bereitstellen des Substrats in einer Prozesskammer beinhaltet und das Verfahren ferner beinhaltet
Ausspülen von Sauerstoff oder Feuchtigkeit aus der Prozesskammer vor Behandeln der Oberfläche mit dem Dampf der Silan-Zusammensetzung, und
Ausspülen des Dampfs der Silan-Zusammensetzung aus der Prozesskammer nach Behandeln der Oberfläche mit dem Dampf der Silan-Zusammensetzung.

7. Verfahren nach Anspruch 1, wobei die Metallstruktur Kupfer beinhaltet, wobei das organische Material gegebenenfalls ABF beinhaltet.

8. Verfahren nach Anspruch 1, wobei das Substrat ein Teil eines Paketsubstrats ist.

9. Verfahren nach Anspruch 1, wobei die Metallstruktur eine Zwischenverbindungsstruktur der elektronischen Vorrichtung ist, wobei die Zwischenverbindungsstruktur gegebenenfalls eine Zwischenverbindungsleitung, eine Leistungsebene, eine Masseebene, ein Durchkontakt oder ein plattiertes Durchgangsloch ist.

10. Verfahren nach Anspruch 1, wobei die Metallstruktur eine Kupfer-Zwischenverbindungsstruktur ist;
wobei der Dampf der Silan-Zusammensetzung einen Siedepunkt unter etwa 250 °C bei einem Druck zwischen etwa 13 und 1300 Pa aufweist; und
wobei das organische Material ABF ist.

11. Verfahren nach Anspruch 10, wobei das Substrat ein Teil eines Paketsubstrats ist und die Kupfer-Zwischenverbindungsstruktur eine Zwischenverbindungsleitung, eine Leistungsebene, eine Masseebene, ein Durchkontakt oder ein plattiertes Durchgangsloch ist.

12. Verfahren nach Anspruch 10, wobei die Silan-Zusammensetzung umfasst
(ii.) N,N'-Bis-[(3-trimethoxysilyl)propyl]ethylendiamin (TMSP-ED).

13. Verfahren nach Anspruch 1, wobei die Metallstruktur eine Kupfer-Zwischenverbindungsstruktur ist;
wobei die Silan-Zusammensetzung (a) mindestens eine primäre Amin-Gruppe oder eine sekundäre Amin-Gruppe und mindestens eine Alkoxysilyl-Gruppe beinhaltet, (b) die Alkoxysilyl-Gruppe Ethoxy, Methoxy, Butoxy, Propoxy oder Isopropoxy sein kann, (c) die Alkoxysilyl-Gruppe eine bis drei gebundene Alkoxy-Gruppen aufweisen kann und (d) einen Siedepunkt unter etwa 250°°C bei einem Druck zwischen etwa 13 und 1330 Pa aufweist; und
wobei Beschichten der behandelten Oberfläche mit einem organischen Material Abscheiden von ABF auf der Oberfläche der Kupfer-Zwischenverbindungsstruktur nach Abscheiden der Monoschicht der Silan-Zusammensetzung beinhaltet.

14. Verfahren nach Anspruch 13, wobei die Silan-Zusammensetzung mindestens einen der folgenden Stoffe beinhaltet
(iii.) Bis-(3-trimethoxysilylpropyl)amin (TMSPA) oder
(xxiv.) N-(6-Aminohexyl)aminomethyltrimethoxysilan.

## Revendications

1. Procédé d'amélioration de l'adhérence d'une interface métal-organique dans un dispositif électronique, comprenant :
la fourniture d'un substrat ayant une structure métallique formée sur celui-ci ;
le traitement d'une surface de la structure métallique avec une vapeur d'une composition de silane, la composition de silane comprenant au moins l'un parmi
(i.) N-(2-Aminoéthyl)-3-aminopropyltriméthoxysilane (AE-APTMS),
(ii.) N,N'-Bis[(3-triméthoxysilyl)propyl] éthylènediamine (TMSP-ED),
(iii.) Bis(3-Triméthoxysilylpropyl)amine, (TMSPA),
(iv.) 3-Mercaptopropyltriméthoxysilane (MPTMS),
(v.) N-(2-Aminoéthyl)-3-aminopropylsilanetriol, 25 % dans l'eau (AE-APST),
(vi.) 3-Thiocyanatopropyltriéthoxysilane, 92 % (TCPTES),
(vii.) N-(6-Aminohexyl)aminométhyltriéthoxysilane,
(viii.) N-(6-Aminohexyl)aminopropyltriméthoxysilane,
(ix.) 1,3-Bis(3-aminopropyl)tetraméthyldisiloxane,
(x.) Bis[3-(triéthoxysilyl)propyl]disulfure, 90 % (TESPDS),
(xi.) Aminoéthylaminopropyl/méthylsilsesquioxane, en solution aqueuse,
(xii.) Aminopropylsilsesquioxane en solution aqueuse (APS),
(xiii.) (2-Diéthylphosphatoéthyltriéthoxysilane),
(xiv.) (2-Diéthylphosphatoéthyl)méthyldiéthoxysilane,
(xv.) N-(2-Aminoéthyl)-3-Aminopropyltriéthoxysilane,
(xvi.) 3-(m-Aminophénoxy)propyltriméthoxysilane,
(xvii.) N-(2-Aminoéthyl)-3-Aminopropylméthyldiméthoxysilane,
(xviii.) N-(2-Aminoéthyl)-3-Aminoisobutylméthyldiméthoxysilane,
(xix.) N-(2-Aminoéthyl)-3-Aminoisobutyldiméthylméthoxysilane,
(xx.) 4-Aminobutyltriéthoxysilane,
(xxi.) (Aminoéthylaminométhyl)phénéthyltriméthoxysilane,
(xxii.) N-(2-Aminoéthyl)-3-Aminopropylméthyldiéthoxysilane,
(xxiii.) N-(2-Aminoéthyl)-11-Aminoundécyltriméthoxysilane,
(xxiv.) N-(6-Aminohexyl)Aminométhyltriméthoxysilane,
(xxv.) m-Aminophényltriméthoxysilane, ou
(xxvi.) p-Aminophényltriméthoxysilane,
et après le traitement de la surface, le revêtement de la surface traitée par un matériau organique ;
**caractérisé en ce que**
le traitement de la surface de la structure métallique comprend le dépôt d'une monocouche de la composition de silane sur la surface traitée.

2. Procédé selon la revendication 1, dans lequel la composition de silane comprend au moins l'un parmi
(ii.) N,N'-Bis[(3-triméthoxysilyl)propyl] éthylènediamine (TMSP-ED),
(iii.) Bis(3-Triméthoxysilylpropyl)amine, (TMSPA),
(v.) N-(2-Aminoéthyl)-3-aminopropylsilanetriol, 25 % dans l'eau (AE-APST),
(vi.) 3-Thiocyanatopropyltriéthoxysilane, 92 % (TCPTES),
(viii.) N-(6-Aminohexyl)aminopropyltriméthoxysilane,
(ix.) 1,3-Bis(3-aminopropyl)tetraméthyldisiloxane,
(x.) Bis[3-(triéthoxysilyl)propyl]disulfure, 90 % (TESPDS),
(xi.) Aminoéthylaminopropyl/méthylsilsesquioxane, en solution aqueuse,
(xii.) Aminopropylsilsesquioxane en solution aqueuse (APS),
(xiii.) (2-Diéthylphosphatoéthyltriéthoxysilane),
(xiv.) (2-Diéthylphosphatoéthyl)méthyldiéthoxysilane,
(xvi.) 3-(m-Aminophénoxy)propyltriméthoxysilane,
(xviii.) N-(2-Aminoéthyl)-3-Aminoisobutylméthyldiméthoxysilane,
(xix.) N-(2-Aminoéthyl)-3-Aminoisobutyldiméthylméthoxysilane,
(xx.) 4-Aminobutyltriéthoxysilane,
(xxi.) (Aminoéthylaminométhyl)phénéthyltriméthoxysilane,
(xxiii.) N-(2-Aminoéthyl)-11-Aminoundécyltriméthoxysilane, ou
(xxiv.) N-(6-Aminohexyl)Aminométhyltriméthoxysilane,

3. Procédé selon la revendication 1, dans lequel la composition de silane comprend au moins l'un parmi
(ii.) N,N'-Bis[(3-triméthoxysilyl)propyl] éthylènediamine (TMSP-ED),
(iii.) Bis(3-Triméthoxysilylpropyl)amine, (TMSPA),
(v.) N-(2-Aminoéthyl)-3-aminopropylsilanetriol, 25 % dans l'eau (AE-APST),
(xxiv.) N-(6-Aminohexyl)aminométhyltriméthoxysilane,
(viii.) N-(6-Aminohexyl)aminopropyltriméthoxysilane, ou
(ix.) 1,3-Bis(3-aminopropyl)tetraméthyldisiloxane.

4. Procédé selon la revendication 1, dans lequel la monocouche a une épaisseur d'environ 0,1 à 1 nm.

5. Procédé selon la revendication 1, dans lequel la composition de silane a un point d'ébullition inférieur à environ 250 °C à une pression comprise entre environ 13 et 1 300 Pa.

6. Procédé selon la revendication 1, dans lequel la fourniture du substrat comprend la fourniture du substrat dans une chambre de traitement, et le procédé comprend en outre
une purge de l'oxygène ou de l'humidité de la chambre de traitement avant de traiter la surface par la vapeur de la composition de silane, et
une purge de la vapeur de la composition de silane de la chambre de traitement après traitement de la surface par la vapeur de la composition de silane.

7. Procédé selon la revendication 1, dans lequel la structure métallique comprend du cuivre, éventuellement dans lequel le matériau organique comprend ABF.

8. Procédé selon la revendication 1, dans lequel le substrat est une partie d'un substrat de boîtier.

9. Procédé selon la revendication 1, dans lequel la structure métallique est une structure d'interconnexion du dispositif électronique, éventuellement dans lequel la structure d'interconnexion est l'un parmi une ligne d'interconnexion, un plan de puissance, un plan de masse, un trou d'interconnexion ou un trou traversant plaqué.

10. Procédé selon la revendication 1, dans lequel la structure métallique est une structure d'interconnexion en cuivre ;
dans lequel la vapeur de la composition de silane a un point d'ébullition inférieur à environ 250 °C à une pression comprise entre environ 13 et 1 300 Pa ; et dans lequel le matériau organique est ABF.

11. Procédé selon la revendication 10, dans lequel le substrat est une partie d'un substrat de boîtier et la structure d'interconnexion en cuivre est l'un parmi une ligne d'interconnexion, un plan de puissance, un plan de masse, un trou d'interconnexion ou un trou traversant plaqué.

12. Procédé selon la revendication 10, dans lequel la composition de silane comprend
(ii.) N,N'-Bis[(3-triméthoxysilyl)propyl] éthylènediamine (TMSP-ED).

13. Procédé selon la revendication 1, dans lequel la structure métallique est une structure d'interconnexion en cuivre ;
dans lequel la composition de silane comprend (a) au moins **un** groupe amine primaire ou un groupe amine secondaire et au moins **un** groupe alcoxysilyle, (b) le groupe alcoxysilyle peut être l'un parmi éthoxy, méthoxy, butoxy, propoxy ou isopropoxy, (c) le groupe alcoxysilyle peut avoir entre **un** et trois groupes alcoxy fixés, et (d) **un** point d'ébullition inférieur à environ 250 °C à une pression comprise entre environ 13 et 1 330 Pa ; et
dans lequel le revêtement de la surface traitée par un matériau organique comprend **un** dépôt d'ABF sur la surface de la structure d'interconnexion en cuivre après le dépôt de la monocouche de la composition de silane.

14. Procédé selon la revendication 13, dans lequel la composition de silane comprend au moins l'un parmi
(iii.) Bis(3-Triméthoxysilylpropyl)amine, (TMSPA), ou
(xxiv.) N-(6-Aminohexyl)aminométhyltriméthoxysilane.
